# EUROPÄISCHE PATENTSCHRIFT

(11) **EP 3 828 508 B1**
(45) Veröffentlichungstag und Bekanntmachung des Hinweises auf die Patenterteilung: **08.03.2023**
(21) Anmeldenummer: 20201718.2
(22) Anmeldetag: 14.10.2020
(51) Int. Cl.: G01D 5/14, G01D 5/56, G01P 3/42, G01R 33/00, G06M 1/10, G11C 11/16

(54) **SENSORELEMENT ZUR SPEICHERUNG VON UMDREHUNGS- ODER POSITIONSINFORMATIONEN**
SENSOR ELEMENT FOR STORING ROTATION OR POSITION INFORMATION
ÉLÉMENT DE CAPTEUR PERMETTANT D'ENREGISTRER DES INFORMATIONS DE ROTATION OU DE POSITION

(30) Priorität: 27.11.2019 DE 102019218351
(43) Veröffentlichungstag der Anmeldung: 02.06.2021
(73) Patentinhaber: Dr. Johannes Heidenhain GmbH, 83301 Traunreut (DE)
(72) Erfinder: SCHNEIDER, Johannes, 83278 Traunstein (DE); HOLZAPFEL, Wolfgang, 83119 Obing (DE); HEUMANN, Martin, 83278 Traunstein (DE)

(56) Entgegenhaltungen:
- DE-A1-102008 037 975
- US-A1- 2018 216 965
- US-A1- 2018 356 252
- US-A1- 2019 195 613

## Beschreibung

Die Erfindung betrifft ein Sensorelement zur Speicherung von Umdrehungs- oder Positionsinformationen beispielsweise für eine Winkel- beziehungsweise Längenmesseinrichtung gemäß dem Anspruch 1.

### GEBIET DER TECHNIK

Winkelmesseinrichtungen werden beispielsweise als Drehgeber zur Bestimmung der Winkellage zweier relativ zueinander drehbarer Maschinenteile verwendet. Häufig werden zu diesem Zweck so genannte Multi-Turn-Winkelmesseinrichtungen eingesetzt, durch die eine absolute Positionsbestimmung über viele Umdrehungen hinweg möglich ist.

Darüber hinaus sind Längenmesseinrichtungen bekannt, bei denen eine lineare Verschiebung zweier relativ zueinander verschiebbarer Maschinenteile gemessen wird. Insbesondere bei Längenmesseinrichtungen mit vergleichsweise großer Messlänge werden oft mehrere Linearmaßstäbe oder identische Skalen aneinander gereiht. Bei derartigen Längenmesseinrichtungen soll eine absolute Positionsbestimmung möglichst über die gesamte Messlänge möglich sein.

Häufig werden derartige Messeinrichtungen beziehungsweise Messgeräte für elektrische Antriebe zur Bestimmung der Relativbewegung bzw. der Relativlage von entsprechenden Maschinenteilen eingesetzt. In diesem Fall werden die erzeugten Positionswerte einer Folgeelektronik zur Ansteuerung der Antriebe über eine entsprechende Schnittstellenanordnung zugeführt.

### STAND DER TECHNIK

In der EP 1 740 909 B1 wird ein Sensorelement für einen Umdrehungszähler beschrieben, bei dem Domänenwände entstehen, wobei das Sensorelement eine spezielle spiralförmige Gestalt aufweist.

Aus der Offenlegungsschrift DE 10 2008 037 975 A1 ist ein Umdrehungszähler bekannt mit einer Schleife eines magnetischen Materials, die spitzenförmige Ausstülpungen in das Innere der Schleife enthält sowie Schleifenbereiche außerhalb der Spitzen aufweist, wobei diese Schleifenbereiche einen Verlauf haben mit Bereichen in denen Krümmungen in stets einer Richtung vorliegen.

### ZUSAMMENFASSUNG DER ERFINDUNG

Der Erfindung liegt die Aufgabe zugrunde ein Sensorelement beziehungsweise ein Speichersystem zu schaffen, das einen Domänenwandleiter umfasst und das ein gegenüber äußeren Einflüssen robustes Betriebsverhalten ermöglicht und vergleichsweise wirtschaftlich herstellbar ist.

Diese Aufgabe wird erfindungsgemäß durch die Merkmale des Anspruches 1 gelöst.

Das Sensorelement zur insbesondere aktiven Speicherung von Umdrehungs- oder Positionsinformationen umfasst einen Domänenwandleiter und ein Substrat, wobei der Verlauf des Domänenwandleiters auf dem Substrat geschlossen umlaufend, kreuzungsfrei und stetig ausgestaltet ist. Weiterhin weist der Domänenwandleiter zumindest einen ersten Bereich mit einer positiven Krümmung und zumindest einen zweiten Bereich mit einer negativen Krümmung auf.

Unter dem Begriff aktive Speicherung ist eine Speicherung zu verstehen, für die das betreffende Sensorelement keine elektrische Hilfsenergie benötigt.

Domänenwandleiter sind im Zusammenhang mit der vorliegenden Erfindung insbesondere Leiterspuren beziehungsweise Leiterbahnen oder Nanodrähte, welche aus einem magnetisierbaren Material bestehen. Information kann in Form von gegensätzlich magnetisierten Regionen (Domänen) in den Domänenwandleitern gespeichert werden. Die Domänen sind durch so genannte Domänenwände getrennt, die durch Magnetfelder verschoben werden können, wobei sich die Positionen der Domänen ändern. Zum Bestimmen ihrer Position sind Ausleseelemente angeordnet, an denen die Domänen beziehungsweise Domänenwände vorbeigeschoben werden. Domänenwandleiter können demnach funktional betrachtet auch als eine Art Schieberegister angesehen werden.

Der Verlauf des Domänenwandleiters bildet eine zusammenhängende Kurve und weist weder einen Sprung noch eine Spitze, Knick oder eine sonstige Unstetigkeitsstelle auf. Unter dem Begriff stetiger Verlauf ist also ein Verlauf des Domänenwandleiters zu verstehen, der gleichmäßig ohne abrupte Richtungsänderungen ausgestaltet ist. Mathematisch ausgedrückt ist also der Verlauf des Domänenwandleiters über seine gesamte Länge stetig und insbesondere differenzierbar, so dass also an jedem Punkt des Verlaufes des Domänenwandleiters eine eindeutige Tangente erzeugbar ist.

Unter dem kreuzungsfreien Verlauf des Domänenwandleiters ist insbesondere zu verstehen, dass sich der Domänenwandleiter in seinem Verlauf nicht kreuzt aber auch nicht in unterschiedlichen Lagen sich kreuzend übereinander geführt ist.

Unter der Krümmung ist die Richtungsänderung entlang des Verlaufes des Domänenwandleiters auf dem insbesondere ebenen Substrat zu verstehen. Bei einem geraden Verlauf ist die Krümmung gleich null, weil sich die Verlaufsrichtung nicht ändert. Sofern die Krümmung ungleich null ist, kann man für den Verlauf des Domänenwandleiters die Krümmung mit Vorzeichen bezüglich einer Orientierung des Normalenbündels der Verlaufs-Kurve definieren. Die Krümmung ist positiv, wenn sie sich in Richtung des Einheitsnormalenvektorfeldes krümmt und negativ, wenn sie sich in die entgegengesetzte Richtung krümmt. Beispielsweise kann der erste Bereich mit der positiven Krümmung als ein konvexer Bereich bezeichnet werden während dann der zweite Bereich mit der negativen Krümmung als ein konkaver Bereich bezeichnet werden kann. Mathematisch ausgedrückt weist also der Verlauf des Domänenwandleiters insbesondere mindestens einen Wendepunkt auf.

Mit Vorteil umfasst das Sensorelement ein insbesondere ebenes Substrat und der Domänenwandleiter ist als eine Leiterbahn auf dem Substrat ausgestaltet.

In weiterer Ausgestaltung der Erfindung beträgt die Breite des Domänenwandleiters weniger als 1000 nm, insbesondere weniger als 500 nm mit Vorteil weniger als 300 nm.

Die Dicke beziehungsweise Schichtdicke des Domänenwandleiters beträgt vorteilhafterweise weniger als 200 nm, insbesondere weniger als 150 nm, insbesondere weniger als 60 nm.

Mit Vorteil weist das Substrat eine Glasschicht und / oder eine Siliziumschicht auf. Insbesondere wenn das Substrat eine Siliziumschicht aufweist, kann das Sensorelement als ein Teil eines CMOS-Chips aufgebaut sein.

Gemäß einer vorteilhaften Variante weist das Sensorelement weiterhin Ausleseelemente auf, durch die (an der jeweiligen Position der Ausleseelemente) der lokale Magnetisierungszustand des Domänenwandleiters bestimmbar ist. Durch die Ausleseelemente ist somit jeweils ein Magnetisierungszustand des Domänenwandleiters bestimmbar. Die Ausleseelemente sind bezüglich des Domänenwandleiters ortsfest angeordnet.

In weiterer Ausgestaltung der Erfindung ist der Domänenwandleiter in einer Schicht zwischen zumindest einem der Ausleseelemente und dem Substrat angeordnet. Alternativ oder ergänzend ist zumindest eines der Ausleseelemente in einer Schicht zwischen dem Substrat und dem Domänenwandleiter angeordnet.

Mit Vorteil sind die Ausleseelemente als GMR- oder TMR-Sensoren ausgestaltet.

Das Sensorelement kann mehrere Domänenwandleiter aufweisen. In diesem Fall weisen die mehreren Domänenwandleiter unterschiedliche Anzahlen von ersten Bereichen oder unterschiedliche Anzahlen von zweiten Bereichen auf. So kann also beispielsweise das Sensorelement einen ersten Domänenwandleiter und einen zweiten Domänenwandleiter aufweisen, wobei der erste Domänenwandleiter eine erste Anzahl von ersten Bereichen aufweist und der zweite Domänenwandleiter eine zweite Anzahl von ersten Bereichen aufweist.

Vorteilhafterweise sind die unterschiedlichen Anzahlen, also die Anzahl der ersten Bereiche des ersten Domänenwandleiters und die Anzahl der ersten Bereiche des zweiten Domänenwandleiters teilerfremd. Bekanntlich ist unter dem Begriff teilerfremd zu verstehen, dass für die betreffenden Anzahlen (natürliche Zahlen) keine natürliche Zahl außer der Eins existiert, die beide Zahlen teilt.

Gemäß einem weiteren Aspekt umfasst die Erfindung auch ein Speichersystem mit einem Sensorelement und mit einem Ausleseelement sowie einer Magnetanordnung. Die Magnetanordnung ist in einer ersten Richtung relativ zum Domänenwandleiter bewegbar. Dadurch wird eine Verschiebung von magnetischen Domänen beziehungsweise von Domänenwänden bewirkt.

Mit Vorteil ist das von der Magnetanordnung erzeugte Magnetfeld bezüglich einer Achse, die parallel zur ersten Richtung verläuft, asymmetrisch ausgestaltet. Diese Betrachtung gilt für eine beliebige gedachte Achse, welche parallel zur ersten Richtung verläuft.

Vorteilhaft ist in weiterer Ausgestaltung der Erfindung das von der Magnetanordnung erzeugte Magnetfeld bezüglich einer Achse, die parallel zu einer zweiten Richtung verläuft, symmetrisch ausgestaltet. Dabei ist die zweite Richtung orthogonal zur ersten Richtung orientiert.

Die Achse, die parallel zur ersten Richtung verläuft und die Achse, die parallel zu einer zweiten Richtung verläuft, liegen insbesondere in einer Ebene, welche parallel zum Substrat orientiert ist.

In weiterer Ausgestaltung des Speichersystems ist die Magnetanordnung als ein Magnetarray ausgestaltet, welches Magnete aufweist, deren Pole in der ersten Richtung versetzt zueinander angeordnet sind.

Mit Vorteil weisen zwei zueinander in der ersten Richtung versetzte Magnete eine um 180° gedrehte Polausrichtung auf. Demnach sind also die betreffenden Magnete so angeordnet, dass die Verbindungslinie zwischen dem Nord- und dem Südpol des einen Magneten parallel zur Verbindungslinie zwischen dem Nord- und dem Südpol des anderen Magneten ist, wobei die Polausrichtung der Magneten entgegengesetzt ist. Die versetzten Magnete können also im Hinblick auf die Polausrichtung als antiparallel zueinander angeordnet bezeichnet werden.

In weiterer Ausgestaltung des Speichersystems weist das Magnetarray Magnete auf, deren Pole in einer zweiten Richtung versetzt zueinander angeordnet sind, wobei die zweite Richtung orthogonal zur ersten Richtung orientiert ist.

Vorteilhafterweise weisen zwei zueinander in der zweiten Richtung versetzte und insbesondere benachbarte Magnete eine um 180° gedrehte Polausrichtung auf.

Mit Vorteil ist der Verlauf des Domänenwandleiters achsensymmetrisch ausgestaltet. Insbesondere kann die betreffende Symmetrieachse parallel zur zweiten Richtung beziehungsweise in der zweiten Richtung verlaufen.

Der Domänenwandleiter weist in der ersten Richtung eine Ausdehnung auf und zwei Magnetpole weisen einen Mittenabstand auf, wobei die Ausdehnung kleiner ist als der Mittenabstand. Hier ist insbesondere die maximale Ausdehnung des Domänenwandleiters in der ersten Richtung zu verstehen. Der Mittenabstand kann insbesondere der Abstand zwischen den wirksamen Mitten der Magnete sein. Beispielsweise kann im Fall von zylindrischen Stabmagneten der Mittenabstand als der Abstand zwischen den Längsachsen der zylindrischen Stabmagnete gesehen werden.

Das Speichersystem ist so ausgestaltet, dass dieses zumindest zwei Domänenwände aufweist, wobei auch Ausgestaltungen mit vier oder mehr Domänenwänden eingesetzt werden können.

Vorteilhafte Ausbildungen der Erfindung entnimmt man den abhängigen Ansprüchen.

Weitere Einzelheiten und Vorteile des erfindungsgemäßen Sensors ergeben sich aus der nachfolgenden Beschreibung von Ausführungsbeispielen anhand der beiliegenden Figuren.

### KURZE BESCHREIBUNG DER ZEICHNUNGEN

Es zeigen die
- Figur 1: eine Draufsicht auf ein Sensorelement,
- Figur 2: eine Detailansicht auf einen Domänenwandleiter,
- Figur 3: einen Magneten einer Magnetanordnung,
- Figur 4: eine Draufsicht auf die Magnetanordnung auf einer Trägerplatte,
- Figur 5: eine Draufsicht auf die Magnetanordnung mit einer schematischen Darstellung eines Magnetfeldes,
- Figur 6: eine Seitenansicht auf ein Skalenelement gemäß einem ersten Ausführungsbeispiel,
- Figur 7: eine Draufsicht auf das Skalenelement und das Sensorelement gemäß dem ersten Ausführungsbeispiel,
- Figur 8: eine schematische Ansicht des Sensorelements und der Magnetanordnung in einer ersten Relativposition zueinander,
- Figur 9: eine Teilansicht des Domänenwandleiters mit eingezeichneten Domänenwänden in der ersten Relativposition,
- Figur 10: eine schematische Ansicht des Sensorelements und der Magnetanordnung in einer zweiten Relativposition zueinander,
- Figur 11: eine Teilansicht des Domänenwandleiters mit eingezeichneten Domänenwänden in der zweiten Relativposition,
- Figur 12: eine schematische Ansicht des Sensorelements und der Magnetanordnung in einer dritten Relativposition zueinander,
- Figur 13: eine Teilansicht des Domänenwandleiters mit eingezeichneten Domänenwänden in der dritten Relativposition,
- Figur 14: eine schematische Ansicht des Sensorelements und der Magnetanordnung in einer vierten Relativposition zueinander,
- Figur 15: eine Teilansicht des Domänenwandleiters mit eingezeichneten Domänenwänden in der vierten Relativposition,
- Figur 16: eine schematische Ansicht des Sensorelements und der Magnetanordnung in einer fünften Relativposition zueinander,
- Figur 17: eine Teilansicht des Domänenwandleiters mit eingezeichneten Domänenwänden in der fünften Relativposition,
- Figur 18: eine schematische Ansicht des Sensorelements und der Magnetanordnung in einer sechsten Relativposition zueinander,
- Figur 19: eine Teilansicht des Domänenwandleiters mit eingezeichneten Domänenwänden in der sechsten Relativposition,
- Figur 20: eine Ansicht des Domänenwandleiters mit eingezeichneten Domänenwänden in der weiteren Relativposition während einer zweiten Umdrehung,
- Figur 21: eine Ansicht des Domänenwandleiters mit eingezeichneten Domänenwänden in der weiteren Relativposition nach vollendeter zweiter Umdrehung,
- Figur 22: eine Ansicht des Domänenwandleiters mit eingezeichneten Domänenwänden in der weiteren Relativposition nach vollendeter dritter Umdrehung,
- Figur 23: eine Ansicht des Domänenwandleiters mit eingezeichneten Domänenwänden in der weiteren Relativposition nach vollendeter vierter Umdrehung,
- Figur 24: eine Ansicht eines Sensorelementes mit einem weiteren Domänenwandleiter,
- Figur 25: eine Draufsicht auf das Skalenelement gemäß einem zweiten Ausführungsbeispiel,
- Figur 26: eine Draufsicht auf das Skalenelement gemäß einem dritten Ausführungsbeispiel,
- Figur 27: eine Draufsicht auf ein Sensorelement gemäß dem vierten Ausführungsbeispiel,
- Figur 28: eine Draufsicht auf eine Magnetanordnung gemäß dem vierten Ausführungsbeispiel,
- Figur 29: eine Seitenansicht auf die Magnetanordnung mit dem Sensorelement gemäß dem vierten Ausführungsbeispiel.

### BESCHREIBUNG DER AUSFÜHRUNGSFORMEN

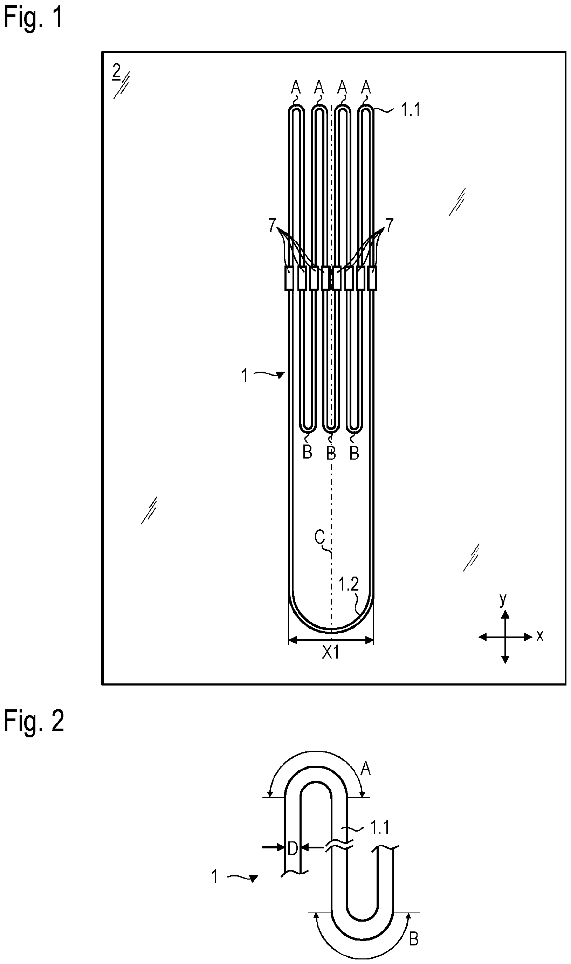

In der Figur 1 ist ein Sensorelement dargestellt, das einen Domänenwandleiter 1 und ein Substrat 2 umfasst, wobei der Domänenwandleiter 1 in Form einer Leiterbahn auf dem Substrat 2 aufgebracht ist. Im vorgestellten Ausführungsbeispiel weist das Substrat 2 eine mechanisch tragende Glasschicht auf, wobei das Substrat 2 eben ausgestaltet ist. Alternativ kann das Substrat 2 eine Siliziumschicht aufweisen, wobei dann das Sensorelement als ein Teil eines CMOS-Chips ausgestaltet sein kann.

Der Domänenwandleiter 1 umfasst ein weichmagnetisches Material beispielsweise eine Ni-Fe-Legierung. Der Domänenwandleiter 1 umfasst einen ersten Abschnitt 1.1, in dem der Domänenwandleiter 1 in vergleichsweise engen Schleifen verläuft und einen zweiten Abschnitt 1.2, in dem der Domänenwandleiter 1 in einem Bogen mit relativ großem Radius verläuft. Der erste Abschnitt 1.1 und der zweite Abschnitt 1.2 grenzen unmittelbar aneinander, so dass der Verlauf des Domänenwandleiters 1 geschlossen umlaufend ausgestaltet ist.

Der Domänenwandleiter 1 weist in einer ersten Richtung x eine Breite X1 auf und ist bezüglich einer Achse C, die senkrecht zur ersten Richtung x und parallel zu einer zweiten Richtung y orientiert ist, symmetrisch ausgestaltet. Im vorgestellten Ausführungsbeispiel beträgt die Breite X1 70 µm, wobei sich der Domänenwandleiter 1 in der zweiten Richtung y über 5 mm erstreckt.

In der Figur 2 ist ein Ausschnitt des Domänenwandleiters 1 gezeigt. Darin ist deutlich zu sehen, dass der Domänenwandleiter 1 in seinem Verlauf einen ersten Bereich A mit einer positiven Krümmung und einen zweiten Bereich B mit einer negativen Krümmung aufweist. Mit anderen Worten ausgedrückt: würde man dem Verlauf des Domänenwandleiters 1 folgen, so würde man sowohl auf einen Abschnitt mit einer Rechtskrümmung als auch auf einen Abschnitt mit einer Linkskrümmung treffen. Im Verlauf des ersten Abschnitts 1.1 folgt auf einen ersten Bereich A mit einer positiven Krümmung ein zweiter Bereich B mit einer negativen Krümmung und darauf wieder ein erster Bereich A usw., wobei im vorgestellten Ausführungsbeispiel sich zwischen den ersten Bereichen A und den zweiten Bereichen B Bereiche mit geradlinigem Verlauf des Domänenwandleiters 1 befinden. Im zweiten Abschnitt 1.2 wechselt das Vorzeichen der Krümmung nicht. Im vorgestellten Ausführungsbeispiel ist die Krümmung beziehungsweise der Krümmungsradius dort konstant ausgestaltet.

In einer Schicht über dem Domänenwandleiter 1 befinden sich gemäß der Figur 1 Ausleseelemente 7, die beispielsweise GMR-Sensoren oder TMR-Sensoren sein können, mit deren Hilfe der Magnetisierungszustand des darunter liegenden Domänenwandleiters 1 festgestellt werden kann. Alternativ können die Ausleseelemente 7 auch zwischen dem Domänenwandleiter 1 und dem Substrat 2 angeordnet sein.

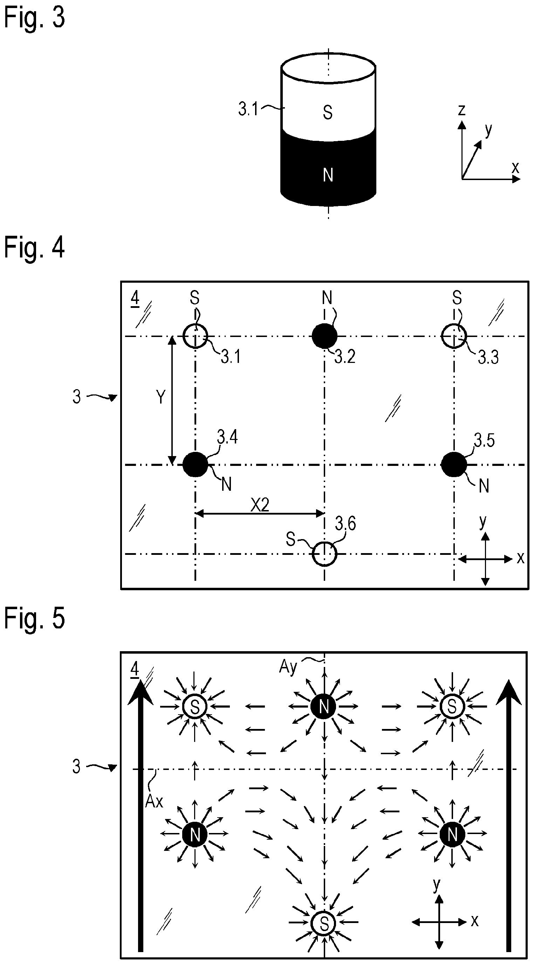

Wenn ein relativ zum Domänenwandleiter 1 bewegtes Magnetfeld geeignet auf den Domänenwandleiter 1 einwirkt, verschieben sich Domänenwände W1, W2 innerhalb des Domänenwandleiters 1 beziehungsweise entlang des Domänenwandleiters 1. Zur Bildung eines geeigneten Magnetfeldes wird eine Magnetanordnung 3 verwendet, die im vorgestellten Ausführungsbeispiel als ein Magnetarray ausgestaltet ist, das aus mehreren Magneten 3.1 bis 3.6 besteht. Beispielhaft für alle Magnete 3.1 bis 3.6 ist in der Figur 3 der Magnet 3.1 dargestellt. Im vorgestellten Ausführungsbeispiel sind sämtliche Magnete 3.1 bis 3.6 identisch ausgestaltet. Demnach sind die Magnete 3.1 bis 3.6 als zylindrische Körper ausgestaltet, wobei die magnetischen Pole entlang der längsten Symmetrieachse im Sinne eines Stabmagneten angeordnet sind.

In der Figur 4 ist eine entsprechende Magnetanordnung 3 gezeigt. Die Magnetanordnung 3 ist im Vergleich zum Domänenwandleiter 1 in der Figur 1 in einem anderen Maßstab dargestellt. Die Magnete 3.1 bis 3.6 werden in unterschiedlicher Nord-Süd-Orientierung auf einem Träger 4 nach einem vorbestimmten Muster angeordnet. Die Magneten 3.1 bis 3.6 können auch in dem Träger 4 eingebettet sein.

Insbesondere können Magnete 3.1 bis 3.3 entlang der ersten Richtung x in einem Abstand X2 aneinander gereiht angeordnet sein, wobei benachbarte Magnete 3.1 und 3.2 beziehungsweise 3.2 und 3.3 eine entgegengesetzte Polausrichtung aufweisen. In einer zweiten Richtung y versetzt sind weitere Magnete 3.4 bis 3.6 entlang der ersten Richtung x ebenfalls im Abstand X2 jeweils aneinander gereiht angeordnet. Im vorgestellten Ausführungsbeispiel beträgt der Abstand X2 0,33 mm. Der Magnet 3.6 befindet sich in der zweiten Richtung y versetzt zu den übrigen Magneten 3.1 bis 3.5.

In Richtung x beidseits neben der Magnetanordnung 3 ist ein Stützmagnetfeld vorgesehen. Somit können die magnetischen Felder vereinfacht gemäß der Figur 5 dargestellt werden, wobei die Pfeile in großer Strichstärke links und rechts neben den Magneten 3.1 bis 3.6 das Stützmagnetfeld andeuten sollen. In der Figur 5 ist erkennbar, dass sich die Richtungen der Magnetfeldlinien so verändern, dass drehende beziehungsweise rotierende Magnetfeldlinien entstehen, wobei die Drehung der Magnetfeldlinien jeweils um Achsen, die in einer dritten Richtung z (siehe Figur 3) orientiert sind, vorliegt.

Das von der Magnetanordnung 3 erzeugte Magnetfeld ist bezüglich einer Achse Ax, die parallel zur ersten Richtung x verläuft, asymmetrisch ausgestaltet. Insbesondere existiert keine Achse, die parallel zur ersten Richtung x verläuft, die eine Symmetrieachse darstellen könnte. Dagegen ist das von der Magnetanordnung 3 erzeugte Magnetfeld bezüglich einer Achse Ay, die parallel zur zweiten Richtung y verläuft, symmetrisch ausgestaltet, so dass bezüglich der Achse Ay ein achsensymmetrisches Magnetfeld vorliegt.

Alternativ zu der hier gezeigten Bauweise können auch Stabmagneten in einer Ebene liegen, die parallel zu ersten Richtung x und parallel zur zweiten Richtung y orientiert ist, so dass die in der Figur 5 dargestellten Nord- und Südpole zumindest teilweise zu ein und demselben Magneten gehören, insbesondere zu Magneten, die in der x-y-Ebene liegen.

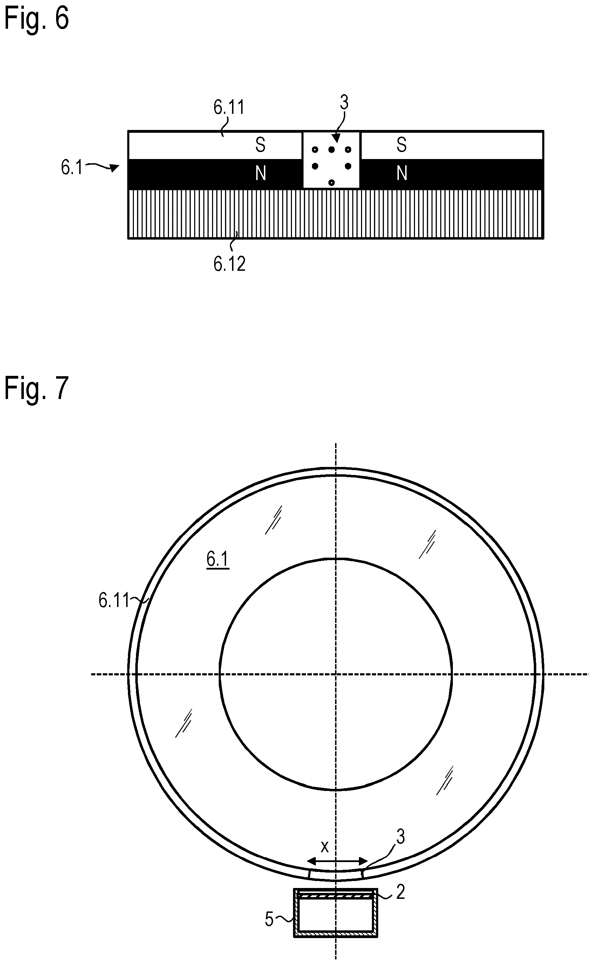

Die Magnetanordnung 3 wird üblicherweise an einem Skalenelement 6 beziehungsweise an einer Maßverkörperung fixiert. Gemäß dem ersten Ausführungsbeispiel nach den Figuren 6 und 7 weist das Skalenelement 6 als Körper eine im Wesentlichen ringförmige Trommel 6.1 auf. An deren Außenumfang ist die Magnetanordnung 3, bestehend aus den Magneten 3.1 bis 3.6 und dem Träger 4 montiert. Zudem weist die Trommel 6.1 im Bereich des Außenumfangs einen Stützmagneten 6.11 auf. Dieser kann beispielsweise aus einer Schicht aus magnetisierbarem Material bestehen. Die Magnetisierung ist so vorgenommen, dass Nord- und Südpol axial versetzt zueinander angeordnet sind. In der zweiten Richtung y also in axialer Richtung versetzt zum Stützmagneten ist im vorgestellten Ausführungsbeispiel eine feine Skala 6.12 umlaufend auf der Trommel 6.1 aufgebracht. Diese kann beispielsweise durch eine optische Abtastung, welche ebenfalls im Gehäuse 5 untergebracht ist, decodiert werden. Alternativ kann die Magnetanordnung 3 auch am Innenumfang einer Trommel beziehungsweise einer Hohlwelle angeordnet sein.

Mit radialem Luftspalt gegenüber liegend befindet sich das Sensorelement, also der Domänenwandleiter 1 mit dem Substrat 2 innerhalb eines Gehäuses 5. Das Gehäuse 5 ist im vorgestellten Ausführungsbeispiel ortsfest, während die Trommel 6.1 mit der Magnetanordnung 3 drehbar gelagert ist, so dass sich die Magnetanordnung 3 bei Drehung der Trommel 6.1 in der ersten Richtung x (beziehungsweise entgegengesetzt) relativ zur Magnetanordnung 3 bewegt.

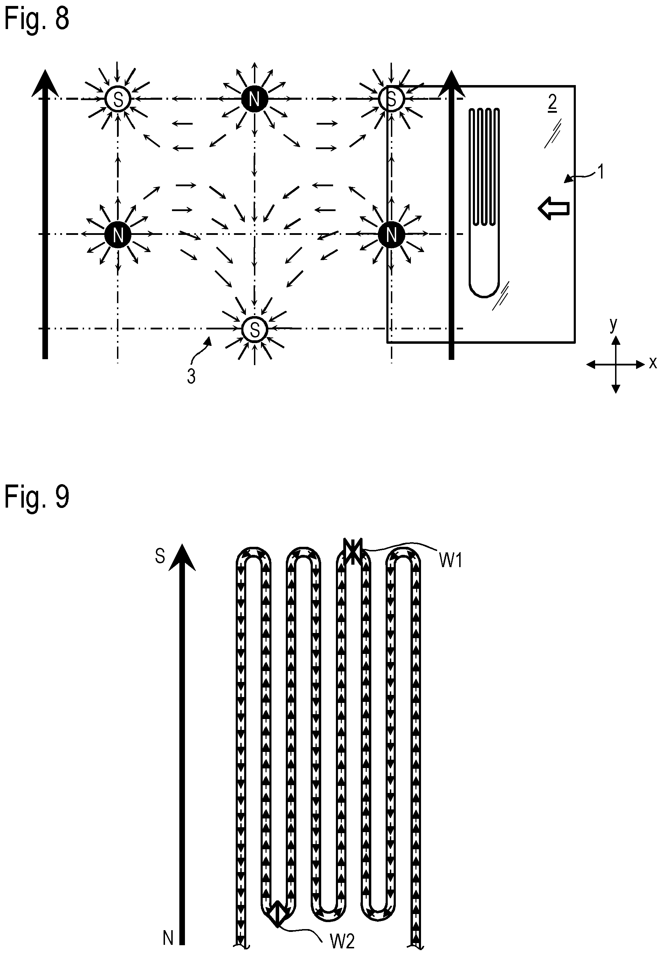

In der Figur 8 sind als Prinzipbild die Magnetanordnung 3 sowie der Domänenwandleiter 1 in einer ersten Stellung zueinander gezeigt. In dieser Stellung befinden sich die Domänenwände W1, W2 in den Positionen gemäß der Figur 9, wobei (wie durch die Symbole dargestellt) die erste Domänenwand W1 eine so genannte head-to-head-Domänenwand ist und die zweite Domänenwand W2 eine so genannte tail-to-tail-Domänenwand. Wenn sich nun der Domänenwandleiter 1 samt Substrat 2 in der ersten Richtung x gemäß dem Pfeil in der Figur 8 relativ zur Magnetanordnung 3 bewegt, wird der Domänenwandleiter 1 quasi durch das sich drehende Magnetfeld, wie in der Figur 5 dargestellt, geführt. Infolgedessen verschieben sich die Positionen der Domänenwände W1, W2.

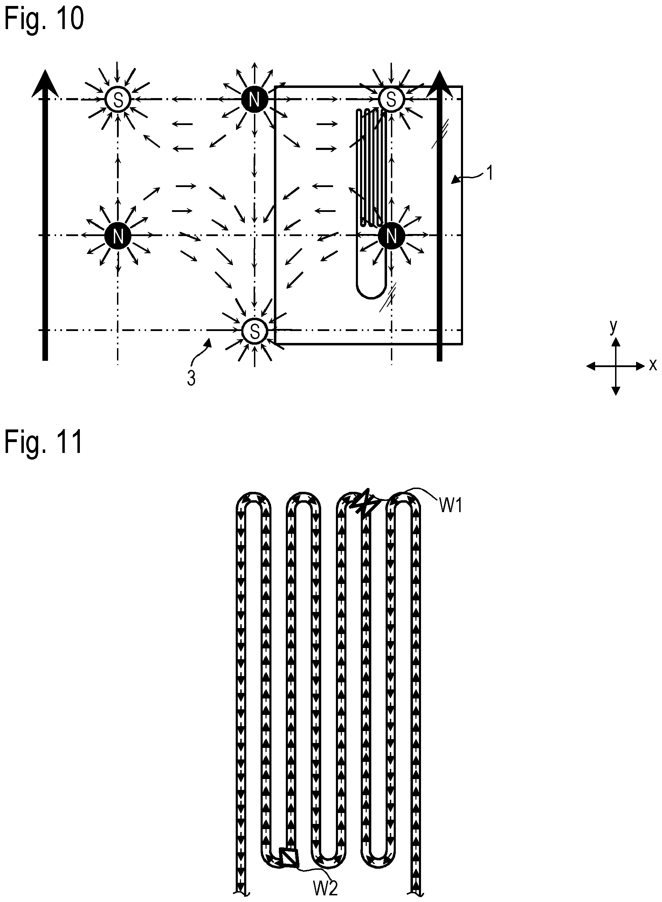

In der Figur 10 ist der Domänenwandleiter 1 in einer weiteren Stellung gezeigt, wobei dort das Magnetfeld gegenüber der ersten Stellung gedreht ist. Dementsprechend haben die Domänenwände W1, W2 ihre Positionen verändert (Figur 11).

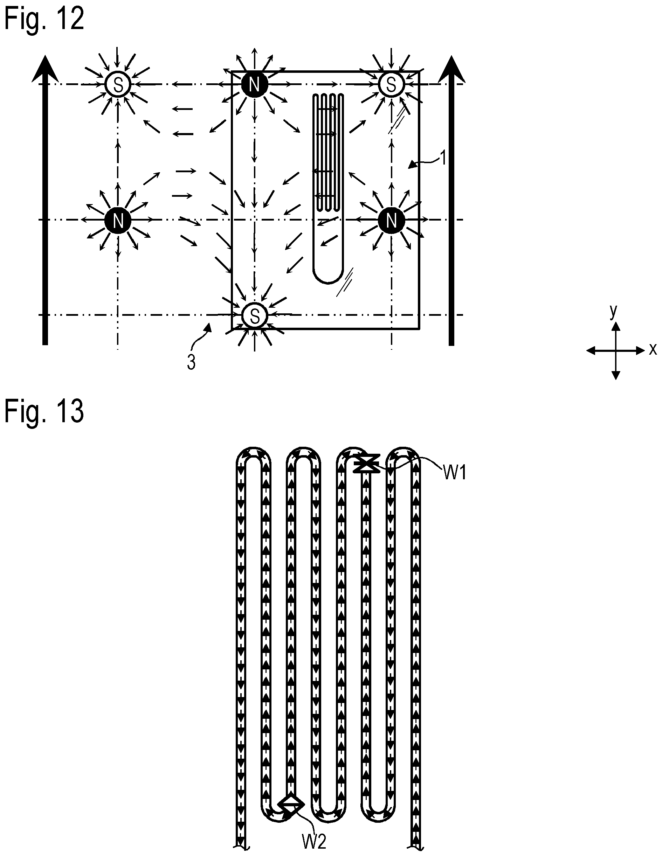

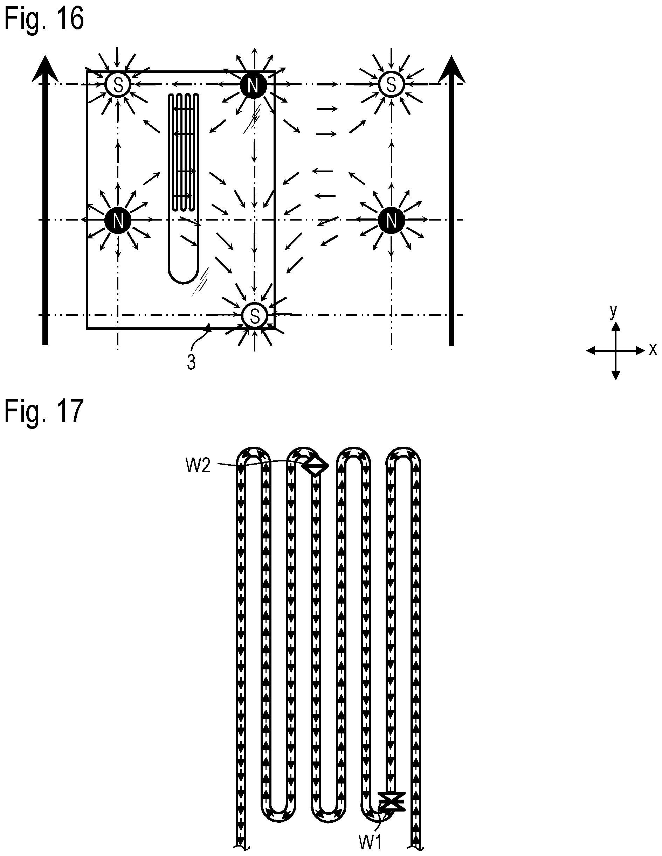

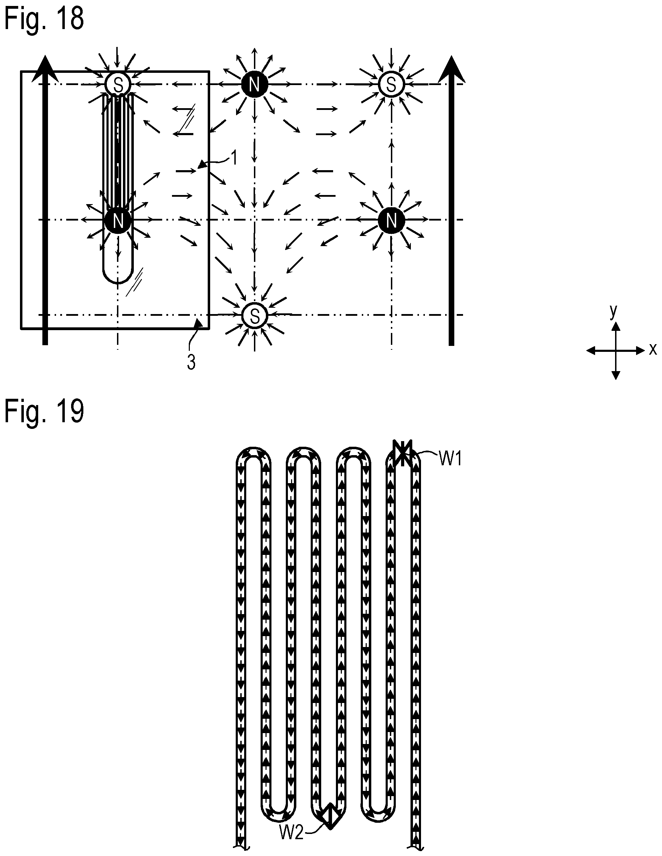

Analog dazu werden infolge einer weiteren Verschiebung des Domänenwandleiters 1 entlang der ersten Richtung x (Figuren 12, 14, 16, 18) die Positionen der Domänenwände W1, W2 weiter verschoben (Figuren 13, 15, 17, 19). Die Positionen der Domänenwände W1, W2 gemäß der Figur 19 beinhalten beispielsweise die Information, dass die Trommel 6.1 eine erste Umdrehung abgeschlossen hat.

Bei einer weiteren Bewegung beziehungsweise Drehung in die gleiche Richtung bleibt der Domänenwandleiter 1 im Einfluss des Stützmagnetfeldes, so dass sich die Positionen der Domänenwände W1, W2 dann nicht mehr verändern.

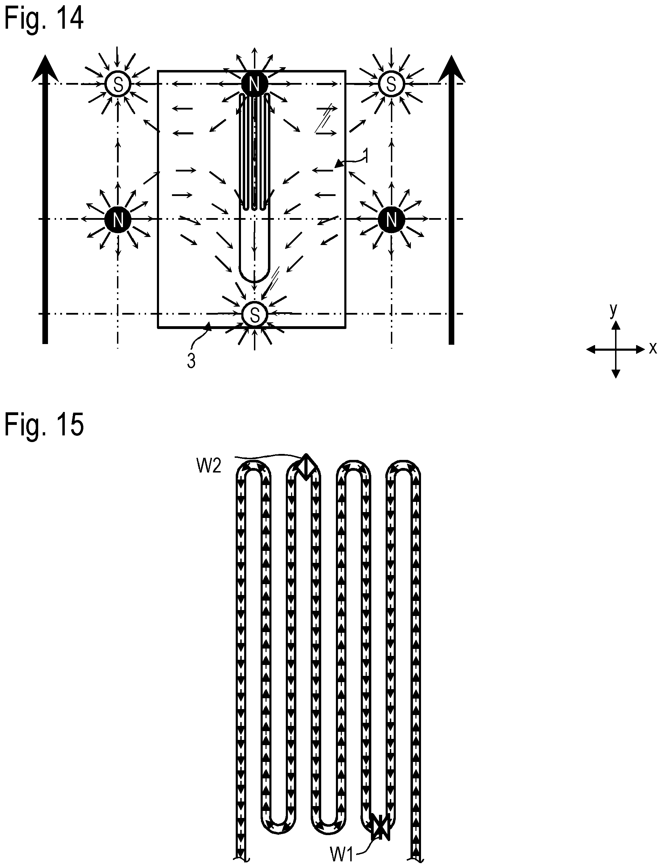

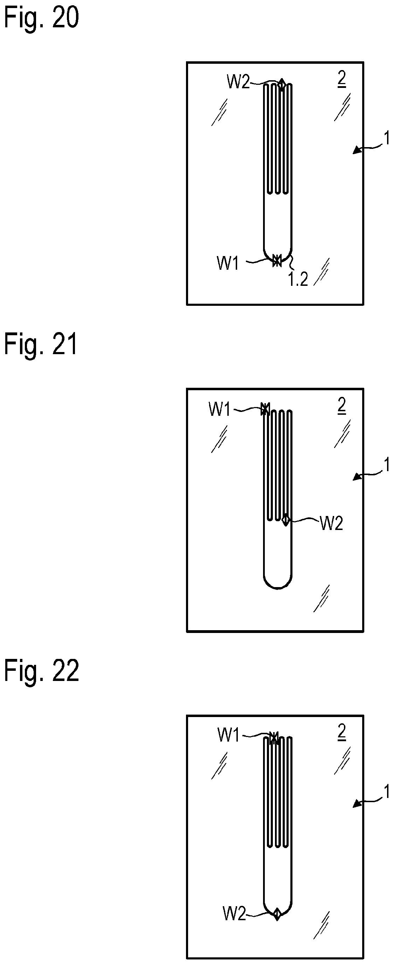

Im vorgestellten Ausführungsbeispiel soll sich die Trommel 6.1 in gleicher Richtung x weiter drehen, so dass der Domänenwandleiter 1 zum Abschluss der zweiten Umdrehung wieder in den magnetischen Einflussbereich der Magnetanordnung 3 kommt. In der Figur 20 sind die Positionen der Domänenwände W1, W2 während der zweiten Umdrehung gezeigt, wobei sich der Domänenwandleiter 1 mit dem Substrat 2 in einer Stellung gemäß der Figur 14 befindet (allerdings ist die Trommel 6.1 dann um 360° weiter gedreht). Insbesondere durch das Magnetfeld des in der zweiten Richtung y versetzt angeordneten Magneten 3.6 beziehungsweise des Stützfeldes wird ein Verschieben der Domänenwände W1, W2 über die Länge des zweiten Abschnitts 1.2, in dem der Domänenwandleiter 1 in einem Bogen mit relativ großem Radius verläuft, erreicht. Am Ende der zweiten Umdrehung, wenn sich der Domänenwandleiter 1 in einer Stellung gemäß der Figur 18 befindet (bezogen auf die Situation in der Figur 18 ist die Trommel 6.1 um 360° weiter gedreht), haben die Domänenwände W1, W2 Positionen gemäß der Figur 21 eingenommen.

In der Figur 22 sind die Positionen der Domänenwände W1, W2 nach einer dritten Umdrehung der Trommel 6.1 gezeigt. In diesem Zustand befindet sich der Domänenwandleiter 1 in einer Stellung gemäß der Figur 18 (allerdings ist die Trommel 6.1 dann um 720° weiter gedreht).

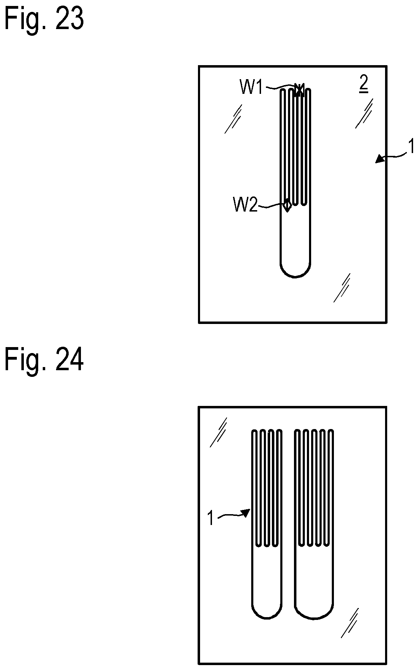

Folglich zeigen die Positionen der Domänenwände W1, W2 gemäß der Figur 23, dass die Trommel 6.1 eine vierte Umdrehung vollendet hat (Stellung der Trommel 6.1 wie bei Figur 18 allerdings um 1080° weiter gedreht). Die Positionen der Domänenwände W1, W2 entsprechen denen des Ausgangszustandes.

Nach jeder Vorbeifahrt der Magnetanordnung 3 beziehungsweise nach jeder Umdrehung der Trommel 6.1 hat sich also die Domänenwand W1 jeweils zu einem benachbarten ersten Bereich A des Domänenwandleiters 1 weiter bewegt. Entsprechend hat sich die Domänenwand W2 nach jeder Umdrehung jeweils zu einem benachbarten zweiten Bereich B des Domänenwandleiters 1 weiter bewegt oder sie befindet sich im zweiten Abschnitt 1.2, in dem der Domänenwandleiter 1 in einem Bogen mit relativ großem Radius verläuft.

Die Magnetisierungsrichtungen innerhalb von Abschnitten des Domänenwandleiters 1 und damit die Grobpositionen der Domänenwände W1, W2 können durch die Ausleseelemente 7 detektiert werden. Auf diese Weise ist eine Zählung von Umdrehungen beziehungsweise Speicherung der Umdrehungsinformation möglich, auch wenn keine Hilfsenergie nutzbar ist. Dies ist beispielsweise wichtig, wenn bei einem Stromausfall eine Welle etwa durch Gewichtbelastung bewegt wird. Die Domänenwände W1, W2 werden im Übrigen drehrichtungsabhängig verschoben, so dass das Sensorelement zuverlässig bei Anwendungen eingesetzt werden kann, die beide Drehrichtungen zulassen.

Um die Anzahl der zählbaren Umdrehungen zu erhöhen können mehrere Domänenwandleiter 1 vorgesehen sein, wie dies vereinfacht in der Figur 24 dargestellt ist. In diesem Fall ist es vorteilhaft, wenn die mehreren Domänenwandleiter 1 unterschiedliche Anzahlen von ersten Abschnitten 1.1 aufweisen, insbesondere unterschiedliche Anzahlen von ersten Bereichen A aufweisen beziehungsweise unterschiedliche Anzahlen von zweiten Bereichen B aufweisen. Bei einer Verwendung von mehreren Domänenwandleitern 1 ist es von Vorteil, wenn die Anzahlen der ersten Bereiche A insbesondere teilerfremd sind. Die mehreren Domänenwandleiter 1 können in der ersten Richtung x zueinander versetzt angeordnet sein oder ineinander verschachtelt. In der Figur 24 sind die Domänenwandleiter so ausgestaltet, dass diese vier und fünf erste Bereiche A aufweisen, wobei in der Figur 24 der Übersichtlichkeit halber Domänenwandleiter mit vergleichsweise kleinen Anzahlen von ersten Bereichen gezeigt sind. In der Praxis bietet es sich an Domänenwandleiter mit mehr als nur vier ersten Bereichen zu verwenden. Beispielsweise können vier Domänenwandleiter verwendet werden mit 7, 9, 11, 13 ersten Bereichen, so dass dann 9009 (7 x 9 x 11 x 13) Umdrehungen zählbar wären.

Für die Funktion des Speichersystems ist es wichtig, dass auf den Domänenwandleiter 1 bei der Vorbeifahrt an der Magnetanordnung 3 entlang der ersten Richtung x ein Magnetfeld einwirkt, dessen Richtung sich in Abhängigkeit von der x-Position ändert. Insbesondere liegen hier bei der Vorbeifahrt drehende beziehungsweise rotierende Magnetfeldlinien beziehungsweise Magnetfeldrichtungen vor. Magnetfeldlinien auf einer Seite der Achse Ax (Figur 5) haben bei der Vorbeifahrt (ohne Richtungsänderung) im Vergleich zu Magnetfeldlinien auf der anderen Seite der einen Achse Ax einen entgegengesetzten Drehsinn.

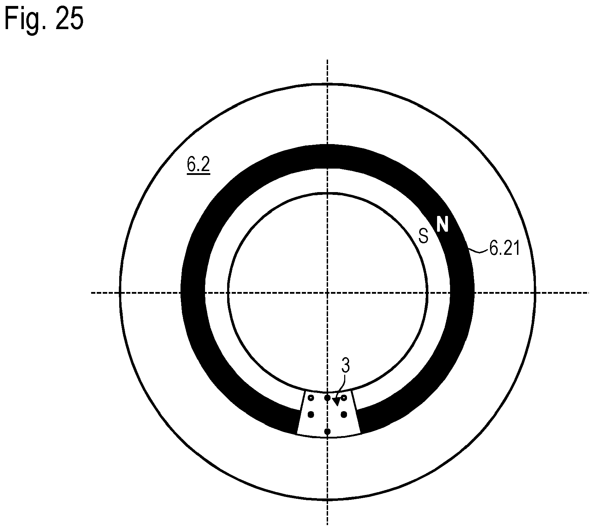

In der Figur 25 ist ein zweites Ausführungsbeispiel gezeigt. Hier wird die Magnetanordnung 3 an einer Stirnseite einer Trommel 6.2 befestigt. Das in der Figur nicht dargestellte Sensorelement wird axial versetzt also mit einem Luftspalt, der eine axiale Ausdehnung aufweist, angeordnet. Bei jeder Vorbeifahrt der Magnetanordnung 3 an dem Sensorelement wird die Umdrehungsinformation aktualisiert, wobei die Domänenwände W1, W2 drehrichtungsabhängig verschoben werden.

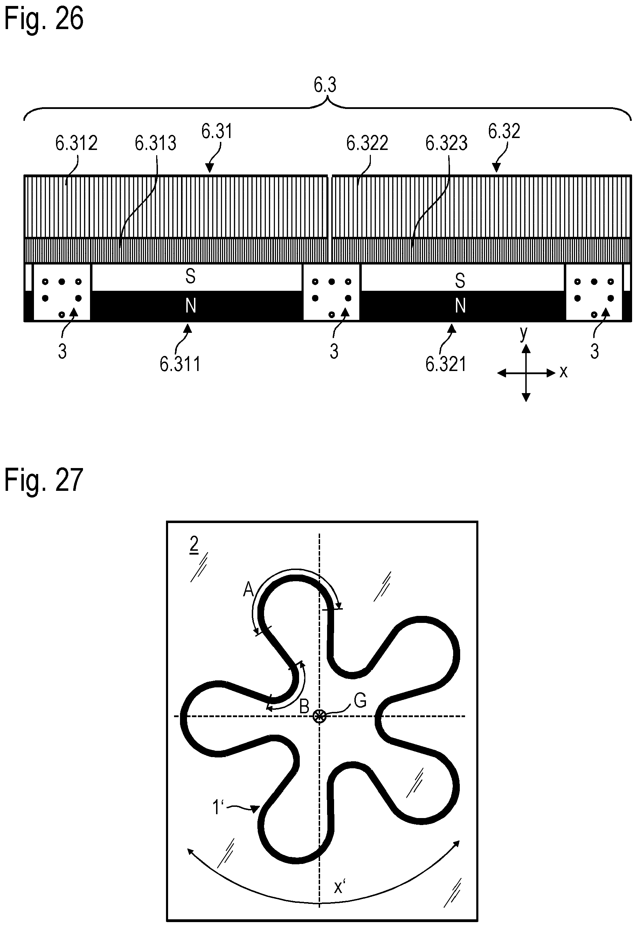

Gemäß der Figur 26 wird ein drittes Ausführungsbeispiel erläutert. Bei diesem Ausführungsbeispiel wird das Sensorelement im Zusammenhang mit einem linearen Maßstab 6.3 eingesetzt. Dieser Maßstab 6.3 umfasst im vorgestellten Ausführungsbeispiel ein erstes Maßstabsteil 6.31 und ein zweites Maßstabsteil 6.32. Das erste Maßstabsteil 6.31 und das zweite Maßstabsteil 6.32 sind entlang der ersten Richtung x aneinandergereiht angeordnet, so dass eine vergleichsweise große Messlänge erreichbar ist. In der Praxis können auch durchaus mehr als nur zwei Maßstabsteile aneinandergereiht angeordnet sein. Das erste Maßstabsteil 6.31 umfasst einen Stützmagnet 6.311 und das zweite Maßstabsteil 6.32 umfasst einen Stützmagnet 6.321. Seitlich in der ersten Richtung x versetzt zu den Stützmagneten 6.311, 6.321 sind die Magnetanordnungen 3 vorgesehen. Ein in der Figur 26 nicht dargestellter Abtastkopf weist ein Sensorelement auf mit dem Domänenwandleiter 1 sowie mit einer Abtasteinrichtung einer Inkrementalspur 6.313, 6.323 und einer Absolutspur 6.312, 6.322 (die Inkrementalspur 6.313, 6.323 und die Absolutspur 6.312, 6.322 erstrecken sich über die zwei Maßstabsteile 6.31, 6.32). Durch das Sensorelement ist es möglich Positionsinformationen zu speichern, so dass feststellbar ist welches der Maßstabsteile 6.31, 6.32 gerade abgetastet wird.

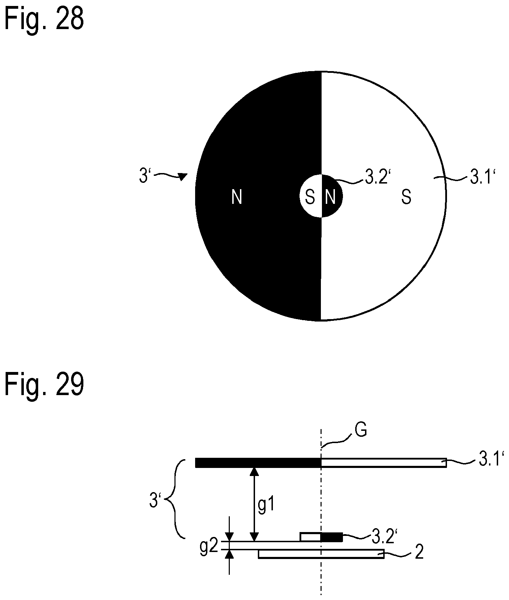

Anhand der Figuren 27 bis 29 kann ein viertes Ausführungsbeispiel erläutert werden. In der Figur 27 ist ein Sensorelement gezeigt, welches einen gegenüber den vorhergehenden Ausführungsbeispielen abgewandelten Domänenwandleiter 1' aufweist, der um einen zentralen Drehpunkt herum verläuft (in der Figur wurde auf die Darstellung von Ausleseelementen verzichtet). Zur Verschiebung der Domänenwände wird beispielhaft eine Magnetanordnung 3' verwendet, welche gemäß der Figur 28 zwei scheibenförmige Magnete 3.1', 3.2` umfasst, die insbesondere unterschiedliche Durchmesser aufweisen. Die Magnete 3.1', 3.2` weisen eine diametrale Magnetisierung auf, so dass die Pole radial zueinander versetzt angeordnet sind. Die Magnete 3.1', 3.2` sind entlang einer Achse G (also axial) zueinander versetzt angeordnet, wobei ihre Polausrichtungen bezüglich der Achse G um 180° verdreht sind. Die Magnete 3.1', 3.2' selbst werden im entsprechenden Speichersystem ortsfest zueinander eingebaut und können sich also nicht zueinander verdrehen oder in irgendeiner Weise zueinander verschieben. Wie in der Figur 29 gezeigt, ist der Abstand g1 zwischen dem Domänenwandleiter 1' beziehungsweise dem Substrat 2 und dem Magneten 3.1' mit dem größerem Durchmesser größer als der Abstand g2 zwischen dem Domänenwandleiter 1' beziehungsweise dem Substrat 2 und dem Magneten 3.2` mit dem kleineren Durchmesser (g1 > g2). Auf diese Weise kann ein Magnetfeld erzeugt werden, durch das eine geeignete Verschiebung von Domänenwänden erreicht wird, wenn der Domänenwandleiter 1' beziehungsweise das Substrat 2 relativ zur Magnetanordnung 3' um die Achse G rotiert beziehungsweise sich entlang der ersten Richtung x' relativ zur Magnetanordnung 3' bewegt. Dadurch ist die Anzahl von Umdrehungen des Substrats 2 relativ zur Magnetanordnung 3' zählbar.

## Patentansprüche

1. Sensorelement zur Speicherung von Umdrehungs- oder Positionsinformationen umfassend einen Domänenwandleiter (1; 1') und ein Substrat (2), wobei der Domänenwandleiter (1; 1') auf dem Substrat (2) angeordnet ist, wobei der Verlauf des Domänenwandleiters (1; 1') geschlossen umlaufend, kreuzungsfrei und stetig ausgestaltet ist und weiterhin der Domänenwandleiter (1; 1') einen ersten Bereich (A) mit einer positiven Krümmung und einen zweiten Bereich (B) mit einer negativen Krümmung aufweist.

2. Sensorelement gemäß dem Anspruch 1, wobei der Domänenwandleiter (1; 1') als eine Leiterbahn auf dem Substrat (2) ausgestaltet ist.

3. Sensorelement gemäß einem der vorhergehenden Ansprüche, wobei die Breite (D) des Domänenwandleiters (1; 1') weniger als 1000 nm beträgt.

4. Sensorelement gemäß einem der vorhergehenden Ansprüche, wobei das Substrat (2) eine Glasschicht und / oder eine Siliziumschicht aufweist.

5. Sensorelement gemäß einem der vorhergehenden Ansprüche, wobei das Sensorelement weiterhin Ausleseelemente (7) aufweist, durch die der lokale Magnetisierungszustand des Domänenwandleiters (1; 1') bestimmbar ist.

6. Sensorelement gemäß dem Anspruch 5, wobei der Domänenwandleiter (1; 1') in einer Schicht zwischen zumindest einem Ausleseelement (7) und dem Substrat (2) angeordnet ist.

7. Sensorelement gemäß dem Anspruch 5 oder 6, wobei zumindest ein Ausleseelement (7) in einer Schicht zwischen dem Substrat (2) und dem Domänenwandleiter 1 angeordnet ist.

8. Sensorelement gemäß einem der Ansprüche 5 bis 7, wobei die Ausleseelemente (7) als GMR- oder TMR-Sensoren ausgestaltet sind.

9. Sensorelement gemäß einem der vorhergehenden Ansprüche, wobei das Sensorelement mehrere Domänenwandleiter (1; 1') aufweist, welche unterschiedliche Anzahlen von ersten Bereichen (A) oder unterschiedliche Anzahlen von zweiten Bereichen (B) aufweisen.

10. Sensorelement gemäß dem Anspruch 9, wobei die unterschiedlichen Anzahlen ersten Bereichen (A) teilerfremd sind.

11. Speichersystem umfassend ein Sensorelement gemäß einem der Ansprüche 5 bis 10 sowie eine Magnetanordnung (3; 3'), welche in einer ersten Richtung (x; x') relativ zum Domänenwandleiter (1; 1') bewegbar ist.

12. Speichersystem gemäß dem Anspruch 11, wobei die Magnetanordnung (3) als ein Magnetarray ausgestaltet ist, welches Magnete (3.1 bis 3.6) aufweist, deren Pole in der ersten Richtung (x) versetzt zueinander angeordnet sind.

13. Speichersystem gemäß einem der Ansprüche 11 oder 12, wobei das Magnetarray Magnete (3.1 bis 3.6) aufweist, deren Pole in einer zweiten Richtung (y) versetzt zueinander angeordnet sind, wobei die zweite Richtung (y) orthogonal zur ersten Richtung (x) orientiert ist.

14. Speichersystem einem der Ansprüche 11 bis 13, wobei in der ersten Richtung (x) der Domänenwandleiter (1) eine Ausdehnung (X1) und zwei Magnetpole der Magnetanordnung (3) einen Mittenabstand (X2) aufweisen, wobei die Ausdehnung (X1) kleiner ist als der Mittenabstand (X2).

15. Speichersystem gemäß einem der Ansprüche 11 bis 14, wobei bezogen auf die erste Richtung (x) neben der Magnetanordnung (3) ein Stützmagnet (6.11) angeordnet ist.

## Claims

1. Sensor element for storing rotation or position information, comprising a domain wall conductor (1; 1') and a substrate (2), wherein the domain wall conductor (1; 1') is arranged on the substrate (2), wherein the course of the domain wall conductor (1; 1') is of a closed circumferential, continuous configuration without crossings and furthermore the domain wall conductor (1; 1') has a first region (A) with a positive curvature and a second region (B) with a negative curvature.

2. Sensor element according to Claim 1, wherein the domain wall conductor (1; 1') is configured as a conductor track on the substrate (2).

3. Sensor element according to one of the preceding claims, wherein the width (D) of the domain wall conductor (1; 1') is less than 1000 nm.

4. Sensor element according to one of the preceding claims, wherein the substrate (2) has a glass layer and/or a silicon layer.

5. Sensor element according to one of the preceding claims, wherein the sensor element further comprises read-out elements (7) by which a local magnetization state of the domain wall conductor (1; 1') is determinable.

6. Sensor element according to Claim 5, wherein the domain wall conductor (1; 1') is arranged in a layer between at least one read-out (7) and the substrate (2) .

7. Sensor element according to Claim 5 or 6, wherein at least one read-out (7) is arranged in a layer between the substrate (2) and the domain wall conductor (1).

8. Sensor element according to one of Claims 5 to 7, wherein the read-out elements (7) are configured as GMR or TMR sensors.

9. Sensor element according to one of the preceding claims, wherein the sensor element has a plurality of domain wall conductors (1; 1'), which have different numbers of first regions (A) or different numbers of second regions (B).

10. Sensor element according to Claim 9, wherein the different numbers of first regions (A) are coprime.

11. Storage system comprising a sensor element according to one of Claims 5 to 10 and a magnet arrangement (3; 3'), which is movable in a first direction (x; x') relative to the domain wall conductor (1; 1').

12. Storage system according to Claim 11, wherein the magnet arrangement (3) is configured as a magnet array which has magnets (3.1 to 3.6) of which the poles are arranged offset in relation to one another in the first direction (x).

13. Storage system according to either of Claims 11 and 12, wherein the magnet array has magnets (3.1 to 3.6) of which the poles are arranged offset in relation to one another in a second direction (y), the second direction (y) being oriented orthogonally in relation to the first direction (x).

14. Storage system according to one of Claims 11 to 13, wherein, in the first direction (x), the domain wall conductor (1) has an extent (X1) and two magnetic poles of the magnet arrangement (3) have a centre-to-centre distance (X2) from one another, wherein the extent (X1) is less than the centre-to-centre distance (X2).

15. Storage system according to one of Claims 11 to 14, wherein, in relation to the first direction (x), a supporting magnet (6.11) is arranged in addition to the magnet arrangement (3).

## Revendications

1. Elément de capteur permettant de stocker des informations de rotation ou de position, comprenant un conducteur de paroi de domaine (1 ; 1') et un substrat (2), dans lequel le conducteur de paroi de domaine (1 ; 1') est disposé sur le substrat (2), dans lequel le tracé du conducteur de paroi de domaine (1 ; 1') est configuré de manière périphérique et fermée, sans croisement et de manière continue, et de en outre, le conducteur de paroi de domaine (1 ; 1') présente une première zone (A) ayant une courbure positive et une deuxième zone (B) ayant une courbure négative.

2. Elément de capteur selon la revendication 1, dans lequel le conducteur de paroi de domaine (1 ; 1') est configuré sous la forme d'une piste conductive sur le substrat (2).

3. Elément de capteur selon l'une quelconque des revendications précédentes, dans lequel la largeur (D) du conducteur de paroi de domaine (1 ; 1') mesure moins de 1000 nm.

4. Elément de capteur selon l'une quelconque des revendications précédentes, dans lequel le substrat (2) présente une couche de verre et/ou une couche de silicium.

5. Elément de capteur selon l'une quelconque des revendications précédentes, dans lequel l'élément de capteur présente en outre des éléments de lecture (7) qui permettent de déterminer l'état de magnétisation local du conducteur de paroi de domaine (1 ; 1').

6. Elément de capteur selon la revendication 5, dans lequel le conducteur de paroi de domaine (1 ; 1') est disposé dans une couche entre au moins un élément de lecture (7) et le substrat (2).

7. Elément de capteur selon la revendication 5 ou 6, dans lequel au moins un élément de lecture (7) est disposé dans une couche entre le substrat (2) et le conducteur de paroi de domaine (1).

8. Elément de capteur selon l'une quelconque des revendications 5 à 7, dans lequel les éléments de lecture (7) sont configurés comme des capteurs GMR ou TMR.

9. Elément de capteur selon l'une quelconque des revendications précédentes, dans lequel l'élément de capteur présente plusieurs conducteurs de paroi de domaine (1 ; 1') qui présentent différents nombres de premières zones (A) ou différents nombres de deuxièmes zones (B).

10. Elément de capteur selon la revendication 9, dans lequel les différents nombres de premières zones (A) sont des nombres premiers.

11. Système de stockage, comprenant un élément de capteur selon l'une quelconque des revendications 5 à 10 ainsi qu'un agencement d'aimants (3 ; 3') qui est mobile dans un premier sens (x ; x') par rapport au conducteur de paroi de domaine (1 ; 1')

12. Système de stockage selon la revendication 11, dans lequel l'agencement d'aimants (3) est réalisé sous la forme d'une matrice d'aimants qui présente des aimants (3.1 à 3.6) dont les pôles sont disposés de manière décalée les uns par rapport aux autres dans le premier sens (x).

13. Système de stockage selon l'une quelconque des revendications 11 ou 12, dans lequel la matrice d'aimants présente des aimants (3.1 à 3.6) dont les pôles sont disposés de manière décalée les uns par rapport aux autres dans un deuxième sens (y), le deuxième sens (y) étant orienté orthogonalement au premier sens (x).

14. Système de stockage selon l'une quelconque des revendications 11 à 13, dans lequel, dans le premier sens (x), le conducteur de paroi de domaine (1) présente une étendue (X1) et deux pôles magnétiques de l'agencement d'aimants (3) présentent une distance de centre à centre (X2), l'étendue (X1) étant inférieure à la distance de centre à centre (X2).

15. Système de stockage selon l'une quelconque des revendications 11 à 14, dans lequel un aimant de support (6.11) est disposé à côté de l'agencement d'aimants (3) par rapport au premier sens (x).
